# EUROPÄISCHE PATENTSCHRIFT

(11) **EP 0 496 941 B1**
(45) Veröffentlichungstag und Bekanntmachung des Hinweises auf die Patenterteilung: **20.12.1995**
(21) Anmeldenummer: 91116178.4
(22) Anmeldetag: 24.09.1991
(51) Int. Cl.: H05K 5/02, F16J 15/16

(54) **Druckausgleichselement für ein wasserdichtes Gehäuse**
Pressure compensating element for sealed housing
Elément d'équilibrage de pression pour boîtier étanche

(30) Priorität: 19.01.1991 DE 4101516
(43) Veröffentlichungstag der Anmeldung: 05.08.1992
(73) Patentinhaber: Firma Carl Freudenberg, 69469 Weinheim (DE)
(72) Erfinder: Sprenger, Manfred, W-6000 Frankfurt/Main 90 (DE); Krompf, Willi, W-6148 Heppenheim (DE)

(56) Entgegenhaltungen:
- EP-A- 0 186 543
- FR-A- 2 637 763

## Beschreibung

Die Erfindung betriffl ein Druckausgleichselement für ein wasserdichtes Gehäuse, umfassend ein eigenfestes Formteil aus zusammengesinterten Partikeln aus PTFE.

Ein solches Druckausgleichselement ist aus der FUNKSCHAU 1976, Heft 18, bekannt. Danach ist ein Druckausgleichselement aus einer PTFE-Folie vorgesehen, das über der Öffnung eines Gehäuses befestigt ist. Dieses Gehäuse dient vorzugsweise zum Schutz elektronischer Schaltungen vor Spritzwasser, beispielsweise in Kraftfahrzeugen.

Ein weiteres Druckausgleichselement ist aus der FR-A-26 37 763 bekannt. Das Druckausgleichselement ist für die Verwendung an einem elektrischen Schaltgerät bestimmt und dient zum Ausgleichen von Druckunterschieden zwischen dem Inneren des Schaltgeräts und dessen Umgebung. Das Druckausgleichselement umfaßt einen ein- oder zweiteiligen Träger, der den Rand einer Membran aus einer streifenförmigen Folie an Ober- und Unterseite derart umfaßt, daß die Membran gewölbt am Träger vorstehend befestigt ist.

Der Erfindung liegt die Aufgabe zugrunde, ein Druckausgleichselement der eingangs genannten Art derart weiterzuentwickeln, daß die für die Funktion des Druckausgleichselements relevanten Bereiche des Formteils frei vom elastomeren Werkstoff des Dichtelements sind und daß das Druckausgleichselement einfach und wirtschaftlich herstellbar ist.

Diese Aufgabe wird erfindungsgemäß bei einem Druckausgleichselement der eingangs genannten Art mit den kennzeichnenden Merkmalen von Anspruch 1 gelöst. Auf vorteilhafte Ausgestaltung nehmen die Unteransprüche Bezug.

Bei dem erfindungsgemäßen Druckausgleichselement ist es vorgesehen, daß das Formteil unlösbar und wasserdicht an einem eine Dichtfläche aufweisenden Dichtelement aus einem elastomeren Werkstoff festgelegt ist, das das Formteil im Bereich seines Außenumfanges umschließt, daß das Formteil radial innerhalb des Dichtelements mit einer Verdichtungszone versehen ist und daß das Formteil im Bereich der Verdichtungszone im wesentlichen porenfrei verdichtet ist. Diese Ausgestaltung ermöglicht eine einwandtfreie Funktion des Druckausgleichselements und verhindert gleichzeitig, daß Flüssigkeitsbestandteile um das Formteil herum in das abzudichtende Gehäuse gelangen. Die im Inneren des Gehäuses angeordneten, vor Feuchtigkeit geschützten Teile, weisen eine längere Gebrauchsdauer bei gleichbleibend guter Funktion auf.

Das Formteil ist radial innerhalb des Dichtelementes mit einer Verdichtungszone versehen, wobei das Formteil im Bereich der Verdichtungszone im wesentlichen porenfrei verdichtet ist. Die Verdichtungszone kann auf den Bereich von zumindest einer umlaufenden Nut beschränkt sein. Hierbei ist von Vorteil, daß das flüssige Elastomer während der Herstellung des Druckausgleichselements nicht in den gesamten PTFE-Körper, der das Formteil bildet, eindringt und so die Gebrauchseigenschaften negativ beeinflußt. Durch die Verdichtungszonen dringt das Elastomer lediglich in den Bereich des Formteils ein und bildet mit diesem eine haltbare und einwandfreie Verbindung, der nicht für die Funktion des Druckausgleichselementes relevant ist. Porenfreie Verdichtungszonen in Form von zumindest einer umlaufenden Nut sind einfach und wirtschaftlich herstellbar.

Die Nut kann einen gerundeten Nutgrund aufweisen. Hierbei ist von Vorteil, daß die Festigkeit des Formteils bei Belastungen in axialer Richtung im Vergleich zu scharfkantigen Nuten wesentlich erhöht ist und sich somit die Gebrauchsdauer des Druckausgleichselementes verlängert. Zur einfacheren Herstellbarkeit der porenfreien Verdichtungszone des Formteiles kann dieses zwei einander gegenüberliegende Nuten aufweisen.

Das Dichtelement kann während seiner Formgebung und Verfestigung an dem Formteil festgelegt sein. Hierbei ist von Vorteil, daß die Lage der Teile zueinander genau vorgegeben und dadurch eine einwandfreie Verbindung zwischen Dichtelement und Formteil gewährleistet ist. Das Dichtelement kann durch Anvulkanisieren mit dem Formteil verbunden sein.

Gemäß einer vorteilhaften Ausgestaltung ist es vorgesehen, daß das Dichtelement das Formteil auf zwei einander gegenüberliegenden Seiten umschließt und daß das Dichtelement ineinander übergehend ausgebildet sein kann. Das Druckausgleichselement ist vielseitig verwendbar und kann in Abhängigkeit vom jeweiligen Anwendungsfall in verschiedenen Lagen eingebaut werden. So ist zum Beispiel denkbar, daß das Druckausgleichselement unter Vorspannung des Dichtelementes in eine kreisförmige Öffnung eines Gehäuses eingepreßt wird. In diesem Fall dichtet die radiale Begrenzungsfläche des Druckausgleichselementes das Innere des Gehäuses gegen die Umgebung ab. Das Druckausgleichselement kann aber auch in axialer Richtung auf einer Gehäusefläche angeordnet sein und durch eine Vorspannung in axialer Richtung gegen diese abdichten. Dadurch, daß das Dichtelement ineinander übergehend ausgebildet ist, dichtet es in jedem Fall gut ab und ist einfach herstellbar. Darüber hinaus kann vorgesehen sein, daß das Dichtelement entlang seiner radialen und axialen Begrenzung wellenförmige Vorsprünge aufweist, die die Dichtwirkung weiter erhöhen.

Das Formteil und das Dichtelement können im wesentlichen kreisförmig begrenzt sein. Die meist kreisförmigen Gehäuseöffnungen, die besonders wirtschaftlich herstellbar sind, können aufgrund des elastomeren Dichtelementes, das das Formteil umschließt, Durchmessertoleranzen aufweisen, ohne daß die Funktion des Druckausgleichselementes beeinträchtigt wird. Neben den kreisförmig begrenzten Druckausgleichselementen für wasserdichte Gehäuse sind aber auch beliebig gestaltete Begrenzungen denkbar, die dem jeweiligen Anwendungsfall angepaßt werden können.

Das Formteil kann mit zumindest zwei nach außen vorspringenden Zentriernocken versehen sein, die in dem der Dichtfläche benachbarten Bereich von dem Dichtelement überdeckt sind. Die Zentriernocken bewirken bei der Herstellung des Druckausgleichselementes eine genaue räumliche Festlegung des Formteils in bezug auf das Dichtelement. Dies ist insbesondere wegen der beispielsweise nutförmigen Verdichtungszonen von Vorteil. Vorteilhaft darüber hinaus ist, daß durch die räumliche Festlegung von Dichtelement und Formteil zueinander geringe Abmessungen des Druckausgleichselementes sowohl in radialer als auch in axialer Richtung zu erzielen sind.

Der Gegenstand der Erfindung wird nachfolgend anhand der als Anlage beigefügten Zeichnung weiter verdeutlicht. Es zeigen:

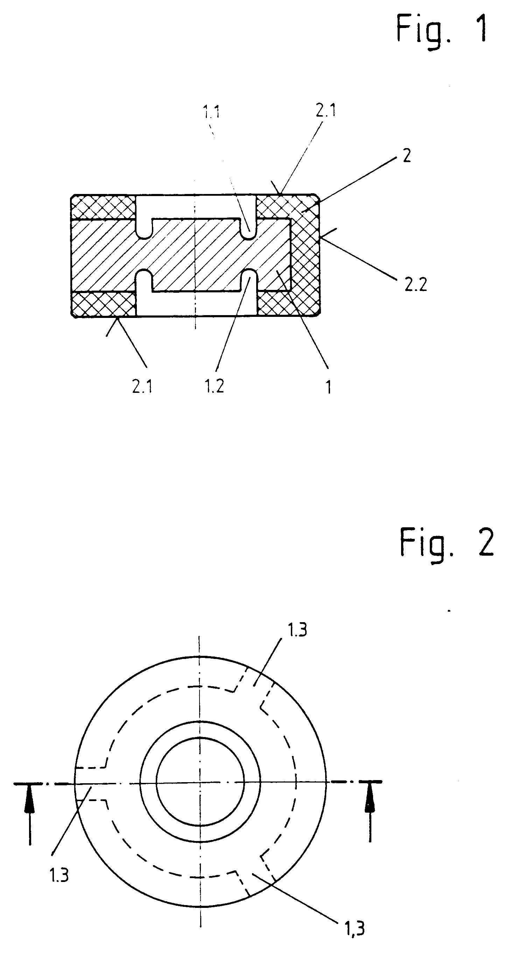

- Figur 1: ein Druckausgleichselement in längsgeschnittener Darstellung;
- Figur 2: das Druckausgleichselement nach Figur 1 in einer Ansicht von oben.

Das gezeigte Druckausgleichselement umfaßt ein eigenfestes Formteil 1 aus zusammengesinterten Partikeln aus PTFE, das unlösbar und wasserdicht an einem Dichtelement 2 aus einem elastischen Werkstoff festgelegt ist. Das Dichtelement 2 umschließt das Formteil 1 auf zwei einander gegenüberliegenden Seiten im Bereich seines Außenumfangs. Die radialen 2.2 und axialen Dichtflächen 2.1 des Dichtelementes 2 sind ineinander übergehend ausgebildet. Das Formteil 1 weist zwei einander gegenüberliegende Nuten 1.1, 1.2 auf, deren Nutgrund eine porenfreie Verdichtungszone begrenzt. Zur genauen räumlichen Festlegung des Formteils 1 im Dichtelement 2 ist das Formteil 1 mit Zentriernocken 1.3 versehen, die in dem der Dichtfläche benachbarten Bereich von dem Dichtelement 2 überdeckt sind. Durch das Dichtelement 2, das das Formteil 1 unlösbar und wasserdicht umgibt, ist ein Eindringen von Flüssigkeit in das abzudichtende Gehäuse ausgeschlossen, wodurch eine erhöhte Gebrauchsdauer des zu schützenden Bauteils gewährleistet ist.

## Patentansprüche

1. Druckausgleichselement für ein wasserdichtes Gehäuse, umfassend ein eigenfestes Formteil (1) aus zusammengesinterten Partikeln aus PTFE, dadurch gekennzeichnet, daß das Formteil (1) unlösbar und wasserdicht an einem eine Dichtfläche aufweisenden Dichtelement (2) aus einem elastomeren Werkstoff festgelegt ist, das das Formteil (1) im Bereich seines Außenumfanges umschließt, daß das Formteil (1) radial innerhalb des Dichtelements (2) mit einer Verdichtungszone versehen ist und daß das Formteil (1) im Bereich der Verdichtungszone im wesentlichen porenfrei verdichtet ist.

2. Druckausgleichselement nach Anspruch 1, dadurch gekennzeichnet, daß die Verdichtungszone auf den Bereich von zumindest einer umlaufenden Nut (1.1) beschränkt ist

3. Druckausgleichselement nach Anspruch 2, dadurch gekennzeichnet, daß die Nut (1.1) einen gerundeten Nutgrund aufweist.

4. Druckausgleichselement nach einem der Ansprüche 1 bis 3, dadurch gekennzeichnet, daß das Formteil (1) zwei einander gegenüberliegende Nuten (1.1, 1.2) aufweist.

5. Druckausgleichselement nach einem der Ansprüche 1 bis 4, dadurch gekennzeichnet, daß Druckausgleichselement nach Anspruch 1, dadurch gekennzeichnet, daß das Dichtelement (2) während seiner Formgebung und Verfestigung an dem Formteil (1) festgelegt ist.

6. Druckausgleichselement nach Anspruch 5, dadurch gekennzeichnet, daß das Dichtelement (2) durch Anvulkanisieren mit dem Formteil (1) verbunden ist.

7. Druckausgleichselement nach einem der Ansprüche 1 bis 6, dadurch gekennzeichnet, daß das Dichtelement (2) das Formteil (1) auf zwei einander gegenüberliegenden Seiten umschließt.

8. Druckausgleichselement nach Anspruch 7, dadurch gekennzeichnet, daß das Dichtelement (2) ineinander übergehend ausgebildet ist.

9. Druckausgleichselement nach einem der Ansprüche 1 bis 8, dadurch gekennzeichnet, das Dichtelement (2) entlang seiner radialen und axialen Begrenzung wellenförmige Vorsprünge aufweist, die dichtend an der Begrenzung der Einbauöffnung des Gehäuses anlegbar sind.

10. Druckausgleichselement nach Anspruch 1 bis 9, dadurch gekennzeichnet, daß das Formteil (1) und das Dichtelement (2) im wesentlichen kreisförmig begrenzt sind.

11. Druckausgleichselement nach Anspruch 1 bis 10, dadurch gekennzeichnet, daß das Formteil (1) mit zumindest zwei nach außen vorspringenden Zentriernocken (1.3) versehen ist und daß die Zentriernocken (1.3) in dem der Dichtfläche benachbarten Bereich von dem Dichtelement (2) überdeckt sind.

## Claims

1. A pressure compensating element for a watertight housing, comprising an inherently strong moulded part (1) of sintered-together PTFE particles, characterized in that the moulded part (1) is fixed undetachably and watertightly on a sealing element (2) of an elastomeric material which has a sealing surface and encloses the moulded part (1) in the region of its outer periphery, in that the moulded part (1) is provided with a compaction zone radially within the sealing element (2) and in that the moulded part (1) is compacted in the region of the compaction zone such that it is substantially free from pores.

2. A pressure compensating element according to claim 1, characterized in that the compaction zone is restricted to the region of at least one peripheral groove (1.1).

3. A pressure compensating element according to claim 2, characterized in that the groove (1.1) has a rounded groove bottom.

4. A pressure compensating element according to any one of claims 1 to 3, characterized in that the moulded part (1) has two mutually opposite grooves (1.1, 1.2).

5. A pressure compensating element according to any one of claims 1 to 4, characterized in that the sealing element (2) is fixed on the moulded part (1) during its shaping and solidifying.

6. A pressure compensating element according to claim 5, characterized in that the sealing element (2) is bonded to the moulded part (1) by being vulcanized on.

7. A pressure compensating element according to any one of claims 1 to 6, characterized in that the sealing element (2) encloses the moulded part (1) on two mutually opposite sides.

8. A pressure compensating element according to claim 7, characterized in that the sealing element (2) is of an integral design.

9. A pressure compensating element according to any one of claims 1 to 8, characterized in that the sealing element (2) has along its radial and axial boundary wave-shaped projections which can be brought to bear in a sealing manner against the boundary of the installation opening of the housing.

10. A pressure compensating element according to any of claims 1 to 9, characterized in that the moulded part (1) and the sealing element (2) are bounded substantially circularly.

11. A pressure compensating element according to any of claims 1 to 10, characterized in that the moulded part (1) is provided with at least two outwardly projecting centring lugs (1.3) and in that the centring lugs (1.3) are covered by the sealing element (2) in the region adjacent to the sealing surface.

## Revendications

1. Elément d'équilibrage de pression pour boîtier étanche à l'eau, comprenant un préformé (1) à stabilité inhérente fait de particules de PTFE frittées, caractérisé en ce que le préformé (1) est fixé, de manière indétachable et étanche à l'eau, sur un élément d'étanchéité (2) en matière élastomère présentant une surface d'étanchéité et entourant le préformé (1) dans la région de sa circonférence externe, en ce que le préformé (1) est pourvu, radialement, à l'intérieur de l'élément d'étanchéité (2), d'une zone de compression, et en ce que le préformé (1) est compressé, dans la région de la zone de compression, essentiellement de manière à être dépourvu de porosités.

2. Elément d'équilibrage de pression selon la revendication 1, caractérisé en ce que la zone de compression est limitée à la région d'au moins une gorge (1.1) périphérique.

3. Elément d'équilibrage de pression selon la revendication 2, caractérisé en ce que la gorge (1.1) est pourvue d'un fond arrondi.

4. Elément d'équilibrage de pression selon l'une des revendications 1 à 3, caractérisé en ce que le préformé (1) est pourvu de deux gorges (1.1, 1.2) situées en face l'une de l'autre.

5. Elément d'équilibrage de pression selon l'une des revendications 1 à 4, caractérisé en ce que l'élément d'étanchéité (2) est fixé sur le préformé (1) pendant son façonnage et sa consolidation.

6. Elément d'équilibrage de pression selon la revendication 5, caractérisé en ce que l'élément d'étanchéité (2) est relié au préformé (1) par vulcanisation.

7. Elément d'équilibrage de pression selon l'une des revendications 1 à 6, caractérisé en ce que l'élément d'étanchéité (2) entoure le préformé (1) sur aux moins deux côtés opposés.

8. Elément d'équilibrage de pression selon la revendication 7, caractérisé en ce que l'élément d'étanchéité (2) est exécuté de manière unitaire.

9. Elément d'équilibrage de pression selon l'une des revendications 1 à 8, caractérisé en ce que l'élément d'étanchéité (2) est pourvu, le long de sa limite radiale et axiale, de saillies ondulées qui peuvent être mises en contact étanche avec le contour de limitation de l'ouverture d'emplacement du boîtier.

10. Elément d'équilibrage de pression selon l'une des revendications 1 à 9, caractérisé en ce que le préformé (1) et l'élément d'étanchéité (2) ont un contour essentiellement circulaire.

11. Elément d'équilibrage de pression selon l'une des revendications 1 à 10, caractérisé en ce que le préformé (1) est pourvu d'au moins deux ergots de centrage (1.3) saillant vers l'extérieur et en ce que les ergots de centrage (1.3) sont couverts par l'élément d'étanchéité (2) dans la zone voisine de la surface d'étanchéité.
